Europäisches Patentamt

European Patent Office

Office européen des brevets

(19)

(11) Numéro de publication: **0 328 537 B1**

## (12) FASCICULE DE BREVET EUROPEEN

(45) Date de publication de fascicule du brevet: **20.01.93**

(51) Int. Cl.5: **H01F 7/02, G01R 33/28**

(21) Numéro de dépôt: **87906826.0**

(22) Date de dépôt: **13.10.87**

(86) Numéro de dépôt internationale :
**PCT/FR87/00392**

(87) Numéro de publication internationale :
**WO 88/02923 (21.04.88 88/09)**

(54) **AIMANT PERMANENT CYLINDRIOUE POUR PRODUIRE UN CHAMP D'INDUCTION UNIFORME ET TRANSVERSE.**

(30) Priorité: **17.10.86 FR 8614417**

(43) Date de publication de la demande:
**23.08.89 Bulletin 89/34**

(45) Mention de la délivrance du brevet:
**20.01.93 Bulletin 93/03**

(84) Etats contractants désignés:
**DE GB IT NL**

(56) Documents cités:
**NL-C- 66 942**
**US-A- 4 614 930**

(73) Titulaire: **GENERAL ELECTRIC CGR S.A.**
**100, rue Camille-Desmoulins**
**F-92130 Issy les Moulineaux(FR)**

(72) Inventeur: **AUBERT, Guy**
**26, cours de la Libération**
**F-38100 Grenoble(FR)**

(74) Mandataire: **Ballot, Paul Denis Jacques et al**
**Cabinet Ballot-Schmit, 7, rue le Sueur**
**F-75116 Paris(FR)**

EP 0 328 537 B1

## Description

La présente invention a pour objet un aimant permanent cylindrique pour produire un champ d'induction uniforme et transverse. Elle trouve son application particulièrement dans le domaine médical où des aimants sont utilisés dàns des expériences d'imagerie par résonance magnétique nucléaire. Elle peut aussi trouver son application dans tous les domaines où de telles distributions d'un champ d'induction magnétique sont requises.

Dans le domaine de l'imagerie par résonance magnétique il est nécessaire de placer les objets à imager, les patients dans le domaine médical, dans un champ d'induction magnétique élevécouramment de 0,1 à 1,5 tesla homogène et uniforme -quelques parties par million de variation -dans un grand volume d'intérêtcouramment une sphère de 50 cm de diamètre. Plusieurs classes de générateurs de champ magnétique ont été développées jusqu'à présent. Les principales sont : les aimants supraconducteurs, les aimants dits résistifs et les aimants permanents. Les aimants permanents ont de nombreux avantages. En particulier ils ne nécessitent pas d'alimentation d'énergie pour produire le champ. Ils ne courent donc pas le risque de dérive de leur valeur de champ due à une dérive de leur alimentation, ou éventuellement du système d'évacuation de la chaleur dissipée. Ils ne nécessitent donc pas de moyens de refroidissement en particulier avec des techniques de régulation sophistiquées de l'écoulement des fluides cryogéniques. Leur température de fonctionnement est aisément stabilisée. Ils sont particulièrement adaptés à la réalisation de structures ou de systèmes produisant un champ principal transverse, c'est-à-dire perpendiculaire à une direction d'introduction des objets, des patients, dans l'aimant.Cette disposition est très favorable à la réalisation d'antennes réceptrices des signaux de résonance à haut gain et très uniforme. Une difficulté importante de l'utilisation des aimants permanents se situe cependant au niveau de leur industrialisation.

Des structures d'aimant permanent produisant un champ magnétique uniforme transverse dans un volume relativement élevé ont été décrites dans l'état de la technique. En particulier dans une demande internationale de brevet n° WO 84/01226 déposée le 23 Septembre 1983 et publiée le 29 Mars 1984 D. LEE et Al. ont décrit un tel aimant. Dans celui-ci la structure cylindrique (en théorie de longueur infinie) est approximée par un empilage d'un certain nombre de sections annulaires munies chacunes d'un certain nombre de blocs aimantés. Les blocs sont répartis sur le pourtour des anneaux en une architecture polygonale qui reproduit autant que possible l'aspect circulaire d'un cylindre théorique. Pour produire un champ transverse à l'axe du cylindre, l'aimantation dans chacun des blocs est constante en module et est orientée, par rapport à la direction du champ d'induction à produire, avec un angle égal au double de celui qui mesure l'angle de repérage du bloc en question par rapport à l'axe de ce cylindre. Les blocs décrits sont d'une manière préférée des volumes prismatiques à section trapézoïdale.

Il résulte de la distribution de l'aimantation ainsi préconisée que l'aimantation de certains blocs doit être orientée, par rapport à ce bloc, selon une direction qui n'est parallèle avec aucun des côtés de la section trapézoïdale. La réalisation de tels blocs magnétiques nécessite donc, industriellement, d'utiliser des aimanteurs spéciaux. Si cette utilisation, quoique plus chère que l'utilisation des aimanteurs standards est encore possible, il n'en va pas de même du façonnage des blocs. En effet, la distribution de l'aimantation imposée dans le cylindre crée une excitation démagnétisante dont l'orientation est rarement parallèle, dans chaque bloc, à celle de l'aimantation. Ceci implique pour la réalisation le choix de matériaux magnétiques dits anisotropes. Or les matériaux magnétiques anisotropes, qui ont par ailleurs les meilleurs propriétés magnétiques, présentent l'inconvénient d'être difficilement usinables dans des directions obliques par rapport à la direction de leur anisotropie. La demande de brevet citée ci-dessus indique, en particulier dans sa figure 5 et dans le texte associé, que la réalisation des blocs peut être obtenue par un empilage de briques élémentaires. Mais il est évident que des briques élémentaires, de formes parallélélipédiques, ont une direction d'aimantation privilégiée parallèle à un côté du parallèlépipède. Aussi il reste qu'il est difficile, d'une part, de tailler les briques en oblique par rapport aux côtés de ce parallélépipède ou, d'autre part, d'aimanter efficacement les blocs constitués dans des directions obliques par rapport aux côtés de ces parallèlépipèdes. En conséquence dans la structure présentée, certains blocs, ceux qui se trouvent dans l'alignement des bissectrices des quatre quadrants, ne peuvent pas facilement être aimantés. La répartition de l'aimantation dans cet aimant conduit en outre à une distribution correspondante de l'exitation démagnétisante. Celle-ci y est telle que par endroits elle peut être suffisante pour diminuer de façon importante l'aimantation. En conséquence l'aimant théoriquement calculé ne peut être réalisé et les performances de l'aimant réel sont bien éloignées de l'idéal.

On connait par ailleurs, par le brevet US-A-4 614 930 une structure à aimantation radiale. Mais cette structure ne présente pas un moment dispolaire nul. De même on connaît, par le document WO 84/01226, une structure d'aimant à anneaux multiples, avec des blocs aimantés dans les anneaux. Mais, dans cette structure le nombre de blocs dans les anneaux est choisi, de sorte qu'avec la consommation de matériau magnétique engagée on n'arrive pas une homognénéité suffisante.

Un aimant d'un tel type présente en outre d'autres inconvénients. En particulier il n'y a pas d'accès technique possible à l'intérieur de la zone d'intérêt hormis l'accès axial. Enfin, comme on le verra à la lecture de la présente description, pour une homogénéité du champ d'induction à atteindre, l'aimant divulgué dans la demande de brevet cité plus haut ne présente pas l'optimum industriel de réalisation : le nombre des sections et la répartition du nombre de blocs dans les sections doit obéir à certaines règles. Et l'homogénéité est dégradée quand elles ne sont pas respectées.

L'invention a pour objet de rémédier aux inconvénients cités. Elle concerne un aimant selon les revendications,

L'invention sera mieux comprise à la lecture de la description et à l'examen des figures qui l'accompagnent. Celles-ci ne sont données qu'à titre indicatif et nullement limitatif de l'invention. Sur les différentes figures les mêmes repères désignent les mêmes éléments. Les cotes et proportions des pièces représentées ne sont pas respectées. Les figures montrent :

- figures 1a et 1b des représentations schématiques de structures d'aimant conformes à l'invention ;
- figure 2 - une autre réalisation possible d'un aimant conforme à l'invention ;
- figures 3 à 6 - les étapes de montage de blocs en matériau magnétique pour obtenir un aimant conforme à celui de la figure 2.

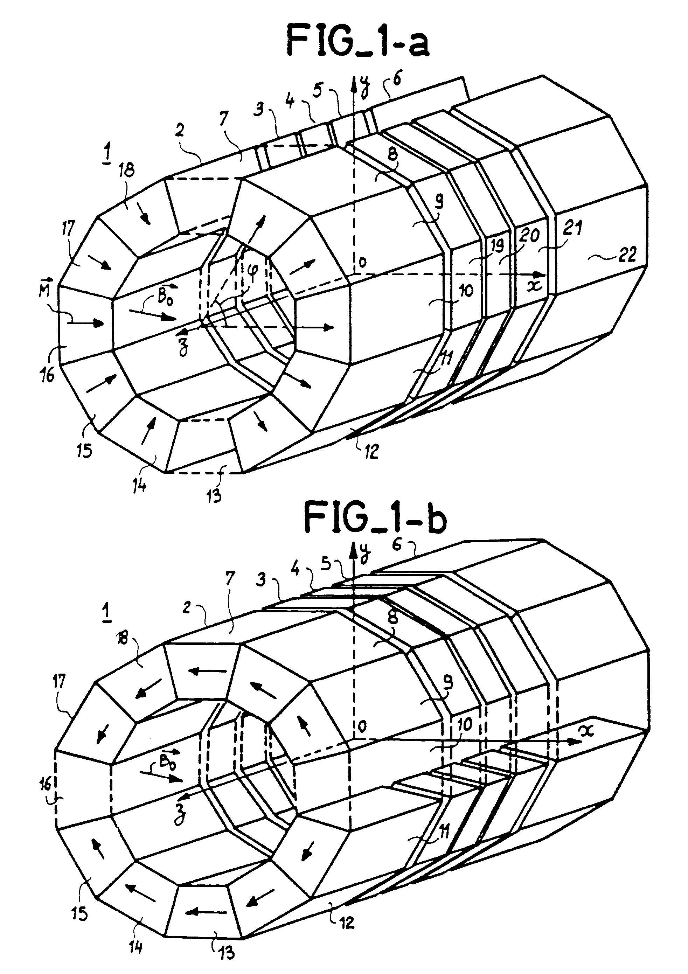

La figure 1a représente schématiquement une structure d'aimant conforme à l'invention. La forme de l'aimant 1 représenté est cylindrique, d'axe z, et est destinée à produire un champ d'induction uniforme $\vec{B}_0$ orienté selon un axe x orthogonal à z. La structure 1 comporte un certain nombre de sections annulaires numérotées 2 à 6. Elle est munie sur le pourtour des sections annulaires d'un certain nombre de blocs aimantés tels que ceux numérotés 7 à 18. Selon une caractéristique essentielle de l'invention tous les blocs aimantés présentent la particularité que leur aimantation $\vec{M}$, représentée par des petites flèches est radiale au cylindre d'axe z. Il en résulte que la fabrication des blocs aimantés s'en trouve facilitée. En effet ces blocs disposés tangentiellement au volume d'intérêt de l'aimant ont toujours des faces orientées tangentiellement ou radialement au cylindre. De plus, alors que dans l'état de la technique cité, pour obtenir le champ uniforme transverse, l'aimantation devait avoir une orientation variable (par rapport à chaque bloc) et une valeur constante, on a découvert qu'un tel champ transverse pouvait être obtenu avec des aimantations selon l'invention si en chaque bloc le module de l'aimantation variait comme le cosinus de l'angle $\phi$ de repérage du bloc par rapport au plan x O z. Cet angle $\phi$ est l'angle du plan médian radial du bloc avec le plan x 0 z. Les blocs étant jointifs, égaux, et au nombre de $n_b$ par section, l'angle de repérage vaut $k\ 2\pi/n_b$ (k entier).

Dans cette première configuration, où la direction de l'aimantation est toujours radiale, les directions d'aimantation des différents blocs ont une allure radiale divergente d'un côté (à droite) et convergente de l'autre à gauche. Dans le bloc 10, ainsi que dans les blocs 19 à 22 (c'est la même chose dans chaque section), l'aimantation doit être nominale. Dans les blocs tels que 9 et 11, elle est réduite ; elle l'est encore plus dans les blocs 8 et 12. A l'endroit des blocs 7 et 13 l'aimantation doit être nulle, puisque l'angle de repérage vaut 90 degrés. Il suffit dans ce cas de ne pas mettre en place de blocs 7 et 13. Ceci a l'avantage d'une part de réduire le coût de la structure et d'autre part de ménager un accès technique par le haut et/ou par le bas d'un tel aimant. Dans la réalisation préférée représentée sur la figure 1, il y a douze blocs par section, dont deux blocs fictifs. Ces blocs possèdent des aimantations respectivement, nominales (dans les blocs 10 et 16), proportionnelles à $\sqrt{3/2}$ fois l'aimantation nominale (dans les blocs 9, 11, 15,17), à la moitié de l'aimantation nominale (dans les blocs 8, 12, 14, 18), et à 0 (dans les blocs 7 et 13).

Dans une structure duale de la précédente (représentée avec des mêmes cotations par la figure 1b) l'aimantation est tangentielle au cylindre. Sa valeur est proportionnelle au sinus de l'angle $\phi$ de repérage des blocs. Les lignes de champ de l'aimantation suivent le sens trigonométriques inverse dans les blocs 15, 14, 13, 12, et 11, et suivent le sens trigonométrique dans les blocs 17, 18, 7, 8, et 9. L'aimantation est nominale en module dans les blocs 7 et 13, elle est nulle dans les blocs 16 et 10. Dans cette configuration l'accès technique à l'intérieur de l'aimant, en plus de l'accès principal longitudinal, peut être ménagé par les blocs 16 et 10 qui ne sont pas présents.

Il est possible de réaliser au choix une des deux solutions. Cependant tous les aimants y compris les aimants permanents, devraient avoir de préférence un moment dipolaire nul. Si ce n'est pas le cas, il devient difficile d'approcher un pupitre de commande, muni d'une console de visualisation avec écran cathodique, dans l'environnement immédiat de l'aimant. Il est bien connu que les indications affichées sur cet écran sont distordues du fait de l'existence du champ magnétique extérieur de l'aimant. Ceci interdit d'ailleurs l'usage de consoles de visualisation en couleurs. Pour éviter ce problème le pupitre de commande doit être éloigné de l'aimant et donc un opérateur qui dirige une expérimentation de RMN se trouve obligatoirement éloigné du patient qui subit un tel examen. Ceci est plutôt néfaste au confort psychologique de ce patient. On note en outre que les praticiens possesseurs d'appareils d'assistance cardiaque, sensibles aussi au champ d'induction parasite, ne peuvent pratiquer des expérimentations de RMN. Dans le but de créer un champ parasite extérieur à l'aimant faible, (on dit que l'aimant a un moment dipolaire total nul), on peut combiner les deux structures correspondantes ensemble.

Dans ce but on peut réaliser deux structures concentriques, l'une étant à aimantation radiale, l'autre étant à aimantation tangentielle. D'une manière préférée, on réalise une structure panachée qui est décrite plus loin. On a découvert qu'une solution panachée nécessite que chaque solution participe au panachage avec des aimantations dans chaque anneaux respectivement proportionnelles à $a_1 \cos \phi$ et à $a_2 \sin \phi$ fois une aimantation nominale commune aux deux solutions. Dans ce cas $a_1$ et $a_2$ doivent être tels que $(a_1)^2 + (a_2)^2$ est inférieur ou égal à 1. En outre le moment dipolaire nul est obtenu lorsque $a_1$ est égal à $a_2$. La solution de ces deux équations indique qu'en prenant des proportions $a_1$ et $a_2$ égales à $\sqrt{1/2}$ on obtient l'intensité du champ d'induction maximum compatible avec un moment dipolaire nul. Si on retient pour chacune des trois solutions (sinus, cosinus, panachée) des mêmes matériaux, susceptibles donc d'avoir une même aimantation nominale, les solutions conduisant à la masse de matériau la plus faible pour réaliser un champ donné, dans un volume donné, sont, de façon sensiblement équivalente, la solution en cosinus et la solution panachée. Cette solution panachée présente en plus l'avantage de conduire à un moment dipolaire nul mais fait perdre aussi le bénéfice d'un accès technique perpendiculaire à l'axe. La solution en sinus est nettement plus lourde.

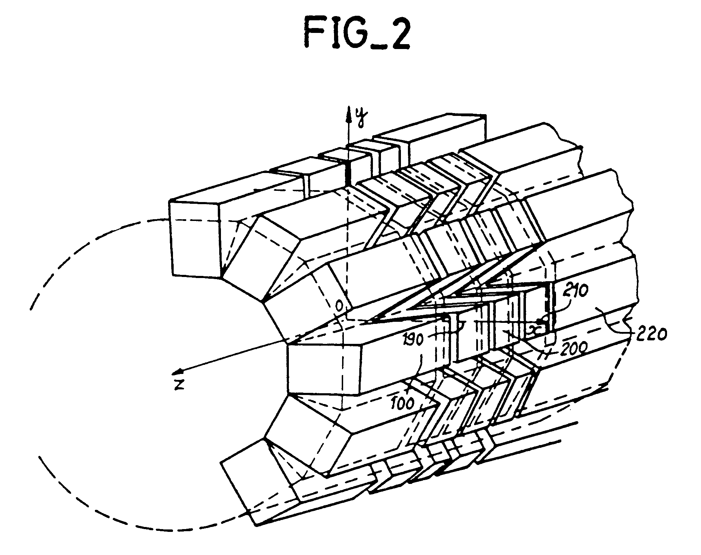

Le choix de l'orientation des aimantations radiales ou tangentielles résout, comme évoqué précédemment, le problème de l'aimantation des blocs. En effet, les blocs sont toujours aimantés selon leurs orientations structurelles (et non pas avec des orientations quelconques par rapport à ces orientations structurelles). La figure 2 montre comment on peut en outre résoudre d'une autre manière le problème de la taille oblique des blocs magnétiques de la figure 1. Sur la figure 1 les blocs magnétiques ont une section trapézoïdale. Les distances des petites bases et des grandes bases des trapèzes à l'axe z du cylindre contribuent à déterminer, avec la valeur de l'aimantation nominale, la valeur de l'induction $B_0$. Sur la figure 2 les sections trapézoïdales ont été remplacées par des sections rectangulaires dont un côté est égal à la petite base des trapèzes. La perte de contribution a l'aimantation, apportée par les sections triangulaires latérales des trapèzes, est compensée par une augmentation en correspondance de l'épaisseur des blocs, mesurée radialement au cylindre. Les blocs 100 et 190 à 220 remplacent respectivement les blocs 10 et 19 à 22 des figures 1a et 1b. Cependant si on utilise des blocs non parallèpipédiques il convient d'exécuter la taille oblique avant l'aimantation.

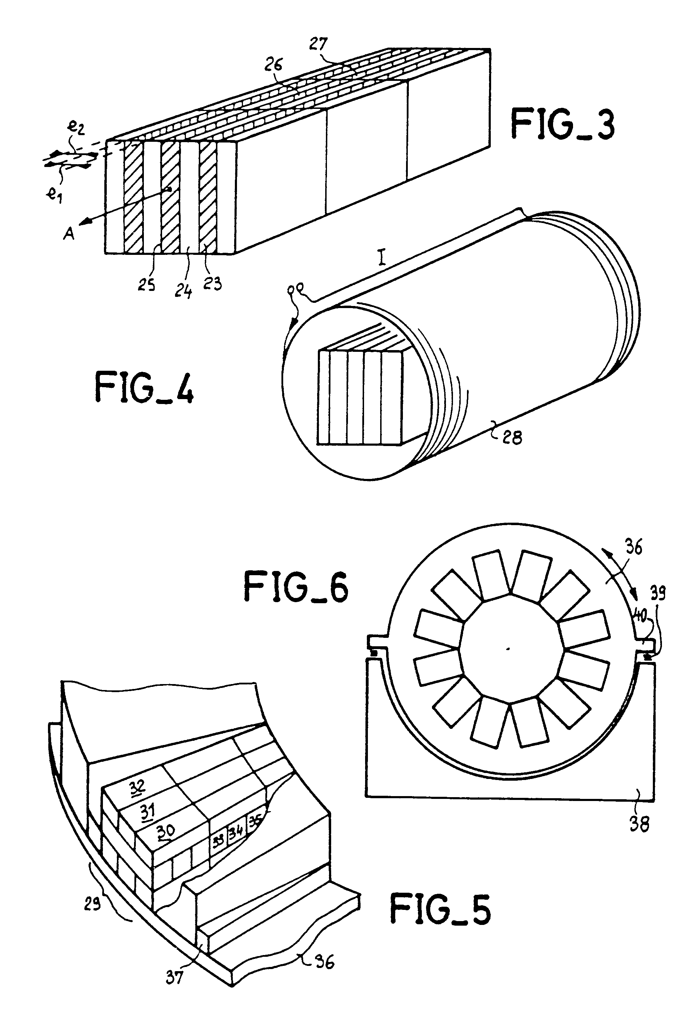

Les figures 3 à 6 montrent les différentes étapes d'un procédé général de construction d'un aimant selon l'invention. Un des premier problème à résoudre consiste à devoir aimanter les blocs avec une aimantation dont le module puisse être réglé. La figure 3 indique qu'on aboutit simplement à ce résultat en accolant des plaques (on pourrait aussi mettre des barres) en matériaux magnétiques 23 à des plaques 24 en matériaux non magnétiques. On règle la proportion du matériau magnétique par rapport au volume général en jouant sur l'épaisseur $e_1$ des plaques magnétiques par rapport à l'épaisseur $e_2$ des plaques non magnétiques. On peut montrer facilement que l'aimantation macroscopiquement équivalente d'un bloc ainsi constitué est égale au produit de l'aimantation intrinsèque des parties en matériaux magnétiques par la proportion $(e_1/(e_1 + e_2))$ de ces matériaux magnétiques dans l'ensemble. A défaut de disposer de plaques 23 de dimension adéquate on peut aussi utiliser des pavés 25 à 27 de matériaux aimantables d'une manière permanente que l'on aboute les uns contre les autres avec un contact très fin et de telle manière que leur anisotropie magnétique A soit alignée et continue, d'une part les uns avec les autres, et d'autre part avec le sens d'aimantation que l'on impose ultérieurement aux blocs. La brique ainsi constituée est de dimension standard. Elle est calculée pour pouvoir être aimantée dans un aimanteur standard tel que l'aimanteur 28 de la figure 4. Le courant I qui parcoure cet aimanteur doit être suffisamment fort, et produire une excitation suffisamment importante, pour que toutes les parties en matériaux aimantables de la brique soient amenées à leur saturation d'aimantation. Si on appelle $M_s$ cette aimantation de saturation, la brique sera aimantée avec une valeur macroscopiquement égale au produit de $M_s$ par la proportion de matériau magnétique.

Les briques aimantées sont ensuite assemblées pour constituer les blocs aimantés décrits jusqu'à présent. Dans la solution à aimantation panachée, les blocs comportent, juxtaposées les unes aux autres, des briques aimantées orthogonalement les unes aux autres. Par exemple, un bloc 29 sur la figure 5 comporte des briques d'aimantation radiale 30 à 32 juxtaposées, ou même empilées, à des briques 33 à 35 d'aimantation tangentielle. L'assemblage des briques dans les blocs peut être effectué de la même manière que l'assemblage des plaques ou des pavés dans les briques : c'est-à-dire avec des colles à base de résine époxy. Les blocs constitués sont ensuite placés sur une couronne 36 en résine époxy. S'il sont rectangulaires ils sont séparés les uns des autres par des cales telles que 37 en forme de coin. En cas de besoin une autre couronne (non représentée) opposée à la couronne 36 peut venir prendre en sandwich les blocs pour assurer la rigidité de la section annulaire. Lors du montage, les couronnes sont logées (figure 6) dans des berceaux tels que 38 sur lesquels elles peuvent reposer par toutes leurs parties inférieures. D'une manière préférée les berceaux 38 et les couronnes 36 sont munies de moyens pour assurer une légère rotation ou un léger décalage, dans un sens ou dans l'autre, aux couronnes. Par exemple une tige filetée 39 reposant sur le berceau 38 peut venir se visser dans une pomelle 40 solidaire de la couronne et provoquer la rotation de cette couronne quand on tourne la tige. De cette manière on dispose d'un moyen simple de corriger industriellement sur le site l'homogénéité de l'aimant construit.

Il est possible de donner une expression analytique de la valeur du champ $B_0$ en fonction des coordonnées du lieu de l'espace où ce champ règne. En particulier si le champ $B_0$ est orienté parallèlement à l'axe x on peut exprimer cette valeur en une série de termes polynoniaux en x, y, z, de puissance croissante. Les coefficients qui pondèrent chacun de ces termes peuvent être affectés à un ordre égal à la puissance du polynôme en x, y, et z concerné. Il est connu que l'homogénéité du champ $B_0$ obtenu est d'autant plus elevée que ces coefficients peuvent être considérés comme nuls jusqu'à un ordre le plus elevé possible. On dit qu'un champ est homogène à un ordre h si tous les termes polynomiaux de puissance inférieure ou égale à h ont un coefficient nul. Dans l'invention on s'est rendu compte que pour un ordre h donné il existait un nombre minimum de section et un nombre minimum de blocs pour lesquels cette homogénéité était atteinte. On s'est rendu compte en outre que cet optimum est aussi applicable à une structure d'aimantation comme celle indiquée dans l'état de la technique cité. On a découvert ainsi que le nombre de section $n_a$ devait être tel que :

$n_a$ supérieur ou égal à (h + 1)/2.

Quant au nombre de blocs par section $n_b$ il doit être tel que :

$n_b$ supérieur ou égal à (h + 3).

Ceci amène aux conclusions suivantes. Premièrement l'optimisation préconisée par l'invention propose une structure minimale c'est-à-dire dont le nombre de blocs à réaliser en définitive est le moins grand possible pour obtenir une homogénéité à un ordre donné. Cette structure minimale est telle que :

$n_b = 2 (n_a + 1)$.

C'est-à-dire un nombre de blocs égal au double du nombre de sections plus une. On remarquera à cet effet que l'aimant représenté jusqu'ici est opimum du point de vue de l'homogénéité car il comporte cinq sections ($n_a$ = 5) et douze blocs par sections ($n_b$ = 12 = 2(5 + 1)). Il est homogène à l'ordre 9, c'est à dire que les polynômes de plus bas degré intervenant dans le développement de son champ sont de degré 10. Ainsi le nombre de blocs à manipuler est faible ce qui facilite la fabrication et le réglage de l'aimant. Deuxièmement autant la fabrication des blocs et des couronnes est relativement facile, autant l'installation et le réglage de ces couronnes est déticat. Aussi et d'une manière préférée on s'arrange pour respecter l'homogénéité recherchée avec un nombre minimal de couronnes, mais par contre on peut mettre en place un nombre de blocs supérieur à ce qu'il est nécessaire. En définitive dans le cas d'une structure panachée la solution industrielle la plus pratique est telle que le nombre de blocs par section est supérieur ou égal au double du nombre de sections plus une. Par contre la solution qui conduit aux plus grandes ouvertures techniques latérales dans le cas d'une structure non panachée, est celle où les blocs sont les plus gros et où leur nombre est donc minimal.

D'une manière préférée, les matériaux magnétiques utilisés sont soit des ferrites, de Strontium ou de Baryum, soit des alliages de Samarium - Cobalt, soit des alliages de Fer-Néodyme-Bore. Ces différents matériaux ont des aimantations rémanentes intrinsèques à saturation différentes. Ils sont par ailleurs de masse volumique et de prix différents. On peut choisir de cette manière, en fonction des différentes spécifications de champ d'induction à produire, quelle est la solution la plus adaptée. Le principe du calcul des rayons intérieurs et extérieurs des sections annulaires ainsi que des hauteurs de ces sections est le même dans le cas de l'invention que celui qui conduit à la détermination des blocs dans l'état de la technique cité. On remarque cependant qu'à rayons intérieurs et extérieurs constants quelle que soit la section, les épaisseurs de ces sections le long de l'axe doivent augmenter quand on s'éloigne du centre de la zone d'intérêt de l'aimant. Ceci apparait en particulier sur les figures 1 et 2.

**Revendications**

1. Aimant permanent cylindrique (1) pour produire un champ d'induction ($B_0$) uniforme et transverse (x) comportant des blocs aimantés (7-18) avec une aimantation permanente, répartis le long du cylindre en des sections annulaires (2-6) disposées le long du cylindre, et distribués régulièrement sur le pourtour de chaque section, l'aimantation, dans les blocs, étant orientée au moins en partie tangentiellement dans chaque bloc par rapport au cylindre, caractérisé en ce que les blocs comportent des briques (30-32) à aimantation radiale et des briques (33-35) à aimantation tangentielle.

2. Aimant selon la revendication 1 caractérisé en ce que l'aimantation est également en partie radiale et en ce que le module de cette aimantation radiale varie d'un bloc à l'autre, comme le cosinus de l'angle de repérage ($\phi$) qui relie la direction du champ transverse à l'azimut de ce bloc.

3. Aimant selon la revendication 1, caractérisé en ce que l'aimantation est au moins en partie tangentielle et en ce que le module de cette aimantation tangentielle varie d'un bloc à l'autre comme le sinus de l'angle de repérage ($\phi$) qui relie la direction du champ transverse à l'azimut de ce bloc.

4. Aimant selon l'une quelconque des revendications 1 à 3 caractérisé en ce que dans chaque bloc les briques à aimantation radiale et les briques à aimantation tangentielle sont en proportion égale pour constituer un aimant à moment bipolaire nul.

5. Aimant selon la revendication 4 caractérisé en ce que le nombre de blocs par section $n_b$ est supérieur ou égal au double du nombre de sections $n_a$ plus une.

6. Aimant selon la revendication 5 caractérisé en ce que $n_b$ est égal à 2 ($n_a$ + 1) (figure 1-2).

7. Aimant selon la revendication 4 caractérisé en ce que $n_a$ vaut 5 , en ce que $n_b$ vaut 12 et en ce que le champ est uniforme à l'ordre 9.

8. Aimant selon l'une quelconque des revendications 1 à 3 caractérisé en ce que les blocs sont montés sur des couronnes (36) mobiles (39, 40) pour corriger l'homogénéité de l'aimant.

9. Aimant permanent cylindrique pour produire un champ d'induction uniforme et transverse comportant des blocs aimantés avec une aimantation permanente, répartis en un nombre $n_a$ de sections annulaires disposées le long du cylindre, et distribués sur le pourtour de chaque section en un nombre $n_b$ de blocs caractérisé en ce que $n_b$ est supérieur ou égal à $2(n_a + 1)$.

10. Aimant selon la revendication 9 caractérisé en ce qu'il est homogène à un ordre h, si $n_a$ est supérieur à (h + 1)/2 et si $n_b$ est supérieur à (h + 3).

11. Aimant selon l'une quelconques des revendications 1 à 10 caractérisé en ce que l'épaisseur des sections annulaires, mesurée parallèlement à l'axe du cylindre, augmente quand on s'éloigne du centre de l'aimant.

**Claims**

1. Cylindrical permanent magnet (1) for producing a uniform and transverse (x) induction field ($B_0$), comprising magnetized blocks (7-18) with permanent magnetization, which are distributed along the cylinder in annular sections (2-6) positioned along the cylinder and which are evenly spaced out over the periphery of each section, the magnetization in the blocks being at least partly orientated tangentially in each block in respect of the cylinder, characterized by the fact that the blocks comprise bricks (30-32) with radial magnetization and bricks (33-35) with tangential magnetization.

2. Magnet in accordance with claim 1, characterized by the fact that the magnetization is also partly radial and that the module of this radial magnetization varies from block to another as the cosine of the reference angle ($\phi$) which connects the direction of the transverse field to the azimuth of this block.

3. Magnet in accordance with claim 1, characterized by the fact that the magnetization is at least partly tangential and that the module of this tangential magnetization varies from one block to another as the sine of the reference angle ($\phi$) which connects the direction of the transverse field to the azimuth of this block.

4. Magnet in accordance with any one of claims 1 to 3, characterized by the fact that in each block the bricks with radial magnetization and the bricks with tangential magnetization are in equal proportion in order to form a magnet with a zero bipolar moment.

5. Magnet in accordance with claim 4, characterized by the fact that the number of blocks per section $n_b$ is above or equal to twice the number of sections $n_a$ plus one.

6. Magnet in accordance with claim 5, characterized by the fact that $n_b$ is equal to $2(n_a + 1)$ (Figures 1 to 2).

7. Magnet in accordance with claim 4, characterized by the fact that $n_a$ is equal to 5, $n_b$ is equal to 12 and the field is uniform to the order 9.

8. Magnet in accordance with any one of claims 1 to 3, characterized by the fact that the blocks are mounted on crowns (36) which are mobile (39, 40) in order to correct the homogeneity of the magnet.

9. Cylindrical permanent magnet for producing a uniform and transverse induction field, comprising magnetized blocks with a permanent magnetization, which are distributed in a number $n_a$ of annular sections arranged along the cylinder and which are spaced out over the periphery of each section in a number $n_b$ of blocks, characterized by the fact that $n_b$ is above or equal to $2b_a + 1$).

10. Magnet in accordance with claim 9, characterized by the fact that it is homogeneous to an order h if $n_a$ is above $(h + 1)/2$ and if $n_b$ is above $\overline{(h + 3)}$.

11. Magnet in accordance with any one of claims 1 to 10, characterized by the fact that the thickness of the annular sections, measured parallel to the axis of the cylinder, becomes greater as the distance from the centre of the magnet increases.

**Patentansprüche**

1. Zylindrischer Permanentmagnet (1) zur Erzeugung eines gleichförmigen und transversalen (X) Magnetfeldes ($B_0$) mit eine Permanentmagnetisierung aufweisenden magnetisierten Blöcken (7-18), die entlang des Zylinders in ringförmige Abschnitte (2-6) aufgeteilt sind, die entlang des Zylinders angeordnet und gleichmäßig über den Umfang des jeweiligen Abschnitts verteilt sind, wobei die Magnetisierung in den Blöcken zumindest teilweise in dem jeweiligen Block bezüglich des Zylinders tangential orientiert ist, dadurch gekennzeichnet, daß die Blöcke Bausteine (30-32) mit radialer Magnetisierung und Bausteine (33-35) mit tangentialer Magnetisierung umfassen.

2. Magnet nach Anspruch 1, dadurch gekennzeichnet, daß die Magnetisierung gleichermaßen teilweise radial ist und daß der Modul dieser radialen Magnetisierung von einem Block zum anderen entsprechend dem Cosinus des Markierungswinkels ($\phi$) variiert, der zwischen der Richtung des querverlaufenden Feldes und dem Azimut dieses Blockes liegt.

3. Magnet gemäß Anspruch 1, dadurch gekennzeichnet, daß die Magnetisierung zumindest teilweise tangential ist und daß der Modul dieser tangentialen Magnetisierung von Block zu Block entsprechend dem Sinus des Markierungswinkels ($\phi$) variiert, der zwischen der Richtung des querverlaufenden Feldes und dem Azimut dieses Blockes liegt.

4. Magnet nach einem der Ansprüche 1 bis 3, dadurch gekennzeichent, daß in jedem Block die Bausteine mit radialer Magnetisierung und die Bausteine mit tangentialer Magnetisierung in gleichem Verhältnis vorgesehen sind, um einen Magneten mit einem bipolaren Moment Null zu bilden.

5. Magnet nach Anspruch 4, dadurch gekennzeichnet, daß die Anzahl der Blöcke pro Abschnitt $n_b$ größer oder gleich der doppelten Anzahl der Abschnitte $n_a$ plus eins ist.

6. Magnet nach Anspruch 5, dadurch gekennzeichnet, daß $n_b$ gleich $2(n_a + 1)$ (Fig. 1-2) ist.

7. Magnet nach Anspruch 4, dadurch gekennzeichnet, daß $n_a$ 5 beträgt, daß $n_b$ 12 beträgt und daß das Feld gleichförmig ist bei der Ordnung 9.

8. Magnet nach einem der Ansprüche 1 bis 3, dadurch gekennzeichnet, daß die Blöcke auf beweglichen (39, 40) Kronen (36) angebracht sind, um die Homogenität des Magneten zu korrigieren.

9. Zylindrischer Permanentmagnet zur Erzeugung eines gleichförmigen und transversalen Magnetfeldes mit eine Permanentmagnetisierung aufweisenden magnetisierten Blöcken, die in eine Anzahl $n_a$ von ringförmigen Abschnitten aufgeteilt sind, die entlang des Zylinders angeordnet und über den Umfang eines jeden Abschnittes in einer Anzahl $n_b$ von Blöcken verteilt sind, dadurch gekennzeichnet, daß $n_b$ größer oder gleich $2(n_a + 1)$ ist.

10. Magnet nach Anspruch 9, dadurch gekennzeichnet, daß er bei einer Ordnung $\underline{h}$ homogen

ist, wenn $n_a$ größer als (h + 1)/2 ist und wenn $n_b$ größer als (h + 3) ist.

11. Magnet nach einem der Ansprüche 1 bis 10, dadurch gekennzeichnet, daß die Stärke der ringförmigen Abschnitte parallel zur Zylinderachse gemessen mit der Entfernung von der Mitte des Magneten zunimmt.

# FIG_1-a

# FIG_1-b

# FIG_2

FIG_3

$e_2$

$e_1$

A

25 24 23

26

27

I

FIG_4

28

FIG_6

36

39

40

FIG_5

32

31

30

33 34 35

29

37

36

38